# EUROPÄISCHE PATENTSCHRIFT

(11) **EP 1 412 645 B1**
(45) Veröffentlichungstag und Bekanntmachung des Hinweises auf die Patenterteilung: **10.11.2004**
(21) Anmeldenummer: 02791426.6
(22) Anmeldetag: 15.05.2002
(51) Int. Cl.: F16B 21/08, H05K 7/14

(54) **GERÄTEKONSTRUKTION**
EQUIPMENT DESIGN
STRUCTURE D'APPAREIL

(30) Priorität: 27.07.2001 AT 11822001
(43) Veröffentlichungstag der Anmeldung: 28.04.2004
(73) Patentinhaber: Siemens AG Österreich, 1210 Wien (AT)
(72) Erfinder: PETRICEK, Martin, A-2020 Hollabrunn (AT); ROTHMAYER, Thomas, A-1180 Wien (AT)
(74) Vertreter: Patentanwaltskanzlei Matschnig
(86) Internationale Anmeldenummer: PCT/AT2002/000147
(87) Internationale Veröffentlichungsnummer: WO 2003/012302

(56) Entgegenhaltungen:
- EP-A- 0 519 856
- US-A- 4 012 155
- US-A- 6 114 757

## Beschreibung

Die Erfindung betrifft ein Montagelement zur Verbindung eines Bauteiles mit einem Schaltungsträger.

Aus der EP 0519 856 A ist ein Montagelement bekannt geworden, welches bei einer wasserdichten Anordnung von Platten auf Dächern und dergleichen Verwendung findet Das bekannte Montageelement weist eine Aufnahme für einen Montageabschnitt einer Abdeckplatte und je einen Schnapphaken, der in eine Montageöffnung einer Rippe einer Trägerstruktur einrastbar ist.

Die US 4 012 155 A beschreibt eine Verbindung zur Zusammenfügung zweier Bauteile, insbesondere von Möbelstücken. Die bekannte Verbindung weist ein männliches und ein weibliches Montageelement auf, wobei das männliche Montageelement in dem weiblichen Montageelement einrastbar ist. Weiters ist jedes Montagelement an einem Bauteil angeordnet, sodass zwei Bauteile durch Zusammenstecken zweier ungleicher Montageelemente miteinander verbunden werden können. Dieses Dokument zeigt im Unterschied zu der Erfindung nicht, dass ein Montagelement zur Verbindung eines Bauteils mit einem Schaltungsträger vorgesehen ist, welches in eine Öffnung des Schaltungsträgers einrastbar ist und eine Aufnahme für einen auf den Schaltungsträger zu montierenden Bauteil aufweist.

Bei der Herstellung elektronischer Geräte, in welchen Schaltungsträger, insbesondere Leiterplatten, vorgesehen sind, kann es bei der Montage von Bauteilen an dem Schaltungsträger zu Beschädigungen kommen. Insbesondere ist die Montage von schweren Bauteilen, wie beispielsweise von Kühlkörpern, auf Schaltungsträgern aufgrund der dazu üblicherweise verwendeten Schraubverbindungen mit einem hohen Beschädigungsrisiko verbunden.

Bei der Verbindung von Kühlkörpern mit dem Schaltungsträger bzw, der Leiterplatte ist bekannterweise ein Verschrauben des Kühlkörpers mit dem Schaltungsträger vor dem Einbau der miteinander verbundenen Baugruppen in ein Gehäuse notwendig. Dieser Arbeitsvorgang benötigt eigene Vorrichtungen und ist darüber hinaus mit der Gefahr verbunden, bereits auf der Leiterplatte montierte Bauteile zu beschädigen.

Bei den bekannten Verbindungsmethoden kann es nicht nur zu Beschädigungen des Bauteiles bzw. des Schaltungsträgers kommen, sondern sie sind auch mit einem hohen Zeitaufwand verbunden, wodurch hohe Herstellungskosten auftreten können.

Es ist daher eine Aufgabe der Erfindung, eine einfach zu realisierende Verbindung zwischen einem Bauteil und einem Schaltungsträger zu schaffen, die es ermöglicht, die Herstellungskosten zu senken und das Risiko einer Beschädigung in Folge der Montage zu minimieren.

Diese Aufgabe wird mit einem Montageelement der eingangs genannten Art erfindungsgemäß dadurch gelöst, das Montagelement eine Aufnahme, mit welcher es formschlüssig mit einem Abschnitt des Bauteiles verbindbar ist sowie zumindest einen Schnapphaken aufweist, welcher in eine Montageöffnung des Schaltungsträgers einrastbar ist, wobei die Aufnahme an zwei einander gegenüberliegenden Innenseitenflächen je zumindest einen, nach innen abstehenden Haltefortsatz aufweist, wobei die Haltefortsätze mit komplementär zu diesen ausgebildeten Ausnehmungen des Abschnittes des Bauteiles in Eingriff bringbar sind.

Durch die formschlüssige Verbindung zwischen dem Montageelement und dem Bauteil lässt sich eine besonders hohe mechanische Stabilität erreichen. Nach Verbinden des Montageelementes und des Bauteiles kann das Bauteil auf den Schaltungsträger aufgeschnappt werden. Es ist ein Verdienst der Erfindung, dass keine Schraubverbindungen notwendig sind, um den Bauteil mit dem Schaltungsträger zu verbinden, wodurch sich die Montage wesentlich vereinfacht und das Beschädigungsrisiko wesentlich minimiert wird.

Eine vorteilhafte Variante der Erfindung sieht vor, dass die Aufnahme von einer Wandung umgeben ist, welche im wesentlichen prismatische Form hat und an zumindest einer Seitenfläche zumindest abschnittsweise offen ist.

Weitere Vorteile lassen sich dadurch erzielen, dass die Wandung an einer ihrer geschlossenen Seitenflächen in einen zylinderförmigen Abstützsockel übergeht, der einen Anschlag für den Schaltungsträger aufweist.

An dem Abstützsockel kann zumindest ein Abstützsockel angeordnet sein.

Eine besonders günstige Variante der Erfindung sieht vor, dass das Montageelement zwei einander gegenüberliegende Schnapphaken mit gegensinnig verlaufenden Einrastrichtungen aufweist

Die beiden Schnapphaken können einen konischen Zapfen bilden, der in die Montageöffnung des Schaltungsträgers formschlüssig einrastbar ist.

Eine besonders günstige Variante der Erfindung sieht vor, dass das Montageelement auf den Abschnitt aufsteckbar ist.

Soll der Bauteil elektrisch gegen den Schaltungsträger isoliert werden, so kann das Montageelement aus elektrisch isolierendem Kunststoff hergestellt ist.

Soll hingegen eine elektrische Verbindung zwischen dem Schaltungsträger und dem Bauteil hergestellt werden, so kann das Montageelement aus Metall hergestellt sein.

Die mechanische Stabilität eines Gesamtgerätes aus Schaltungsträger und zu montierendem Bauteil lässt sich dadurch erhöhen, dass zur Verbindung des Bauteiles und des Schaltungsträgers mit einem den Schaltungsträger und den Bauteil fassenden Gehäuse das Montageelement zumindest eine von einer der äußeren Seitenflächen der Wandung nach außen abstehende Nase aufweist, welche mit einer Öffnung einer Seitenwand des Gehäuses formschlüssig verbindbar ist.

Die Erfindung samt weiteren Vorteilen wird im folgenden anhand einiger nicht einschränkender Ausführungsbeispiele näher erläutert, die in der Zeichnung dargestellt sind, in dieser zeigen:
- Fig.1: einen Bauteil mit erfindungsgemäßen Montageteilen;
- Fig. 2: den Bauteil aus Fig. 1 der mittels erfindungsgemäßer Montageteile mit einem Schaltungsträger verbunden ist;
- Fig. 3: eine perspektivische Darstellung eines den Bauteil und den Schaltungsträger umfassenden Gehäuses;
- Fig. 4: einen Querschnitt entlang der Linie IV-IV in Fig. 3;
- Fig. 5: ein Schnitt entlang der Linie V-V in Fig.1;
- Fig. 6: eine Draufsicht auf ein erfindungsgemäßes Montageelement aus der Richtung VI in Fig. 5;
- Fig. 7: einen Querschnitt entlang der Linie VII-VII in Fig. 5 und
- Fig. 8a - 8e: Draufsichten auf ein erfindungsgemäßes Montagelement aus unterschiedlichen Perspektiven.

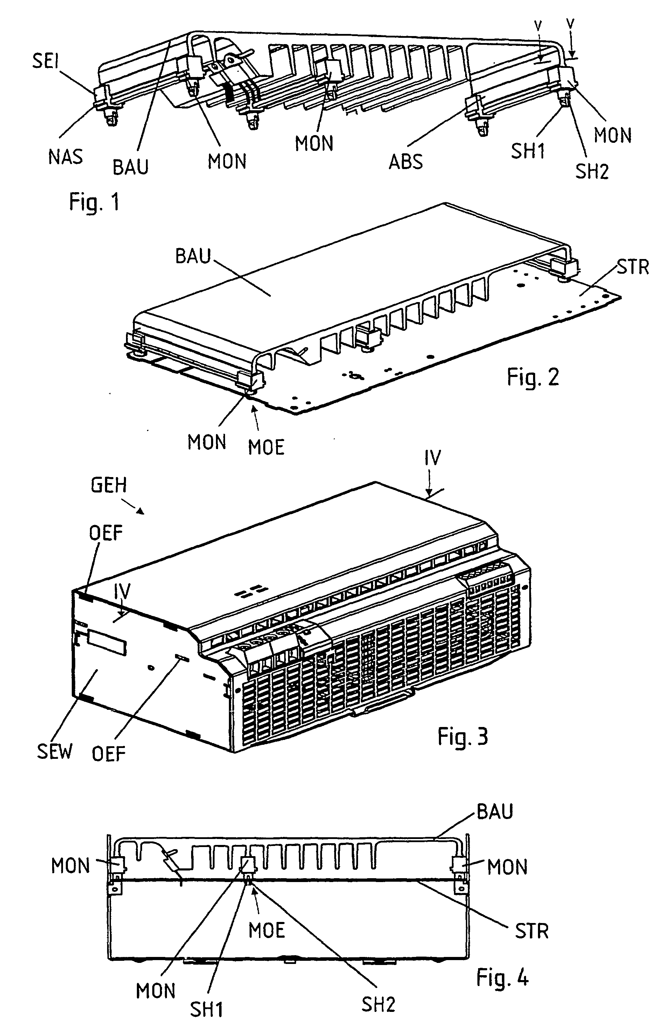

Gemäß Fig. 1 und 2 ist zur Verbindung eines Bauteiles BAU, beispielsweise eine Kühlkörpers, mit einem Schaltungsträger STR, beispielsweise einer Leiterplatte, ein erfindungsgemäßes Montageelement MON vorgesehen. Das Montageelement MON ist so ausgebildet, dass es mit einem Abschnitt ABS des Bauteiles BAU formschlüssig verbindbar ist. Vorzugsweise ist dass Montageelement MON auf den Abschnitt ABS des Bauteiles BAU aufsteckbar.

Die Aufnahme AUF kann von einer Wandung umgeben ist, welche im wesentlichen prismatische Form hat und an zumindest einer Seitenfläche SEI, hier zwei Seitenflächen SEI, zumindest abschnittsweise offen ist, sodass der Abschnitt ABS des Bauteiles BAU in die Aufnahme AUF eingeführt werden kann.

Um das Montageelement MON auf dem Schaltungsträger STR fixieren zu können und dadurch eine mechanisch stabile Verbindung von Bauteil BAU und Schaltungsträger STR zu schaffen, weist das Montageelement MON zumindest einen Schnapphaken SH1, SH2 auf, der nach Fig. 2 und Fig. 4 in eine Montageöffnung MOE des Schaltungsträgers STR einrastbar ist, sodass eine formschlüssige Verbindung zwischen Montageelement MON und Schaltungsträger STR hergestellt ist.

Um die mechanische Stabilität der Verbindung des Bauteils BAU mit dem Schaltungsträger STR weiter zu erhöhen kann das Montageelement MON eine im wesentlichen normal zu einer Seitenfläche SEI seiner Wandung nach außen verlaufende Nase NAS aufweisen, welche nach Fig. 3 mit einer Öffnung OEF einer Seitenwand SEW eines den Schaltungsträger STR und den Bauteil BAU fassenden Gehäuses GEH formschlüssig verbindbar ist.

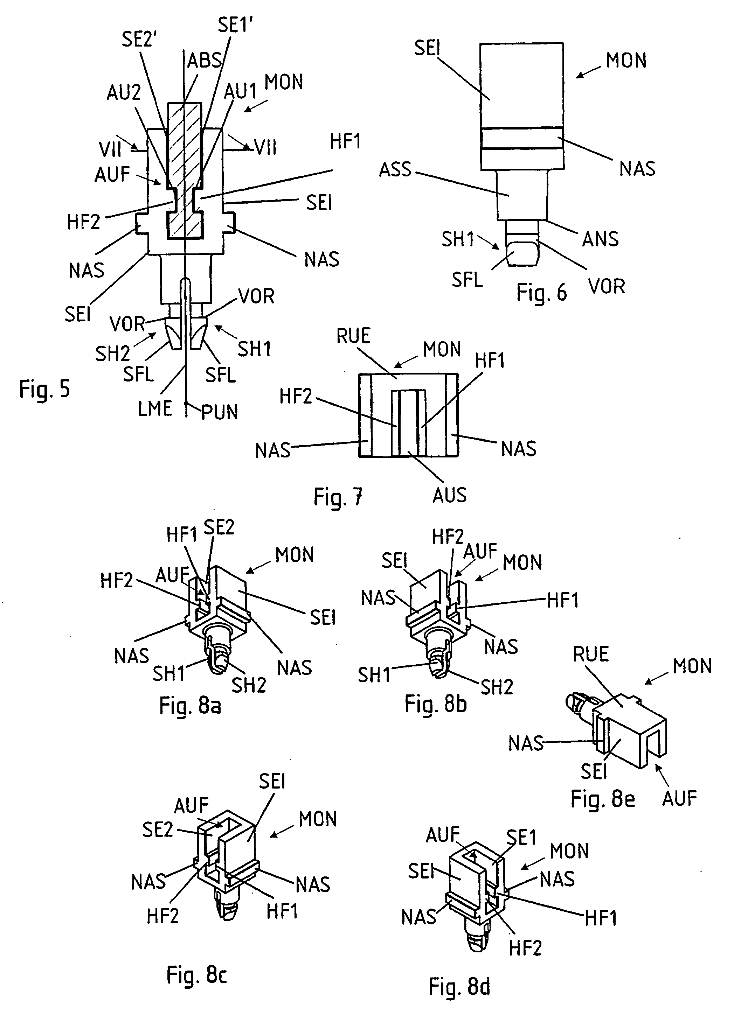

Nach Fig. 5 weist das Montageelement MON zur Aufnahme des Abschnittes ABS des Bauteiles BAU, wie bereits oben erwähnt, eine Aufnahme AUF auf, die von einer prismatischen, abschnittsweise offenen Wandung begrenzt wird. An zwei einander gegenüberliegenden Innenseitenflächen SE1', SE2' der Wandung kann je zumindest ein, von den Innenseitenflächen SE1', SE2' abstehender Haltefortsatz HF1, HF2 vorgesehen sein, wobei die Haltefortsätze HF1, HF2 mit komplementär zu diesen ausgebildeten Ausnehmungen AU1, AU2 des Abschnittes ABS des Bauteiles BAU in Eingriff bringbar sind.

Zur Verbindung des Montageelementes MON und des Schaltungsträgers STR sind nach Fig. 5 zwei Schnapphaken SH1, SH2 mit gegensinnigen Einrastrichtungen vorgesehen.

Für die beiden Schnapphaken ist eine gemeinsame Montageöffnung vorgesehen, die derart bemessen ist, dass die beiden Haken bei der Montage gegen eine Federkraft zunächst gegeneinander gebogen werden und in der Endposition der Schaltungsträger STR auf Vorsprüngen VOR der Schnapphaken SH1, SH2 anliegt, sodass, wie bereits oben erwähnt, eine formschlüssige Verbindung zwischen Schaltungsträger STR und Montageelement MON hergestellt ist.

Um ein Einführen der Schnapphaken SH1, SH2 in die Montageöffnung MOE zu erleichtern können die beiden Schnapphaken SH1, SH2 so ausgebildet sein, dass sie zusammen im wesentlichen die Form eines konischen Zapfens bilden. D. h. die der Längsmittelebene LME des Montagelementes MON abgewandten Seitenflächen SFL der Schnapphaken SH1, SH2 können so zur Längsmittelebene LME des Montageelementes MON hin geneigt sein, dass eine Fortsetzung der Seitenflächen SFL die Längsmittelebene LME in einem außerhalb des Montageelementes MON liegenden und der Aufnahme AUF gegenüberliegenden Punkt PUN schneidet.

Nach Fig. 6 geht die Wandung an einer ihrer geschlossenen Seitenflächen SEI in einen zylinderförmigen Abstützsockel ASS über, der einen Anschlag ANS für den Schaltungsträger STR aufweist, wobei zumindest ein Schnapphaken SH1, SH2 an dem Abstützsockel ASS angeordnet ist. Die abgeschrägten Seitenflächen SFL der Schnapphaken SH1, SH2 können in Richtung des Abstützsockels ASS zur Abstützung des Montageelementes MON an dem Schaltungsträgers STR in den Vorsprung VOR übergehen.

Gemäß Fig. 7 und den Fig. 8a - 8b kann die Aufnahme AUF des Montageelementes MON durch eine Rückwand RUE begrenzt sein. Mit dieser Ausführungsform der Erfindung kann ein Verrutschen des Bauteiles BAU in Längsrichtung der Haltefortsätze HF1 sehr effektiv unterbunden werden. Durch eine spiegelverkehrte Anordnung zweier derartig ausgebildeter Montageelement MON an dem Bauteil BAU (Fig.1 und 2) kann auch eine hohe mechanische Stabilität erreicht werden.

Soll der Bauteil BAU elektrisch gegen den Schaltungsträger isoliert werden, was beispielsweise bei Kühlkörpern der Fall ist, so kann das Montageelement aus einem elektrisch isolierenden Kunststoff hergestellt sein. Für den Fall, dass eine elektrische Verbindung zwischen dem Bauteil und dem Schaltungsträger vorgesehen ist, kann das Montageelement MON aber auch aus Metall hergestellt sein.

## Patentansprüche

1. Montagelement (MON) zur Verbindung eines Bauteiles (BAU) mit einem Schaltungsträger (STR), **dadurch gekennzeichnet, dass** das Montagelement (MON) eine Aufnahme (AUF), mit welcher es formschlüssig mit einem Abschnitt (ABS) des Bauteiles (BAU) verbindbar ist, sowie zumindest einen Schnapphaken (SH1, SH2) aufweist, welcher in eine Montageöffnung (MOE) des Schaltungsträgers (STR) einrastbar ist, wobei die Aufnahme (AUF) an zwei einander gegenüberliegenden Innenseitenflächen (SE1', SE2') je zumindest einen, nach innen abstehenden Haltefortsatz (HF1, HF2) aufweist, wobei die Haltefortsätze (HF1, HF2) mit komplementär zu diesen ausgebildeten Ausnehmungen (AU1, AU2) des Abschnittes (ABS) des Bauteiles (BAU) in Eingriff bringbar sind.

2. Montagelement nach Anspruch 1, **dadurch gekennzeichnet, dass** die Aufnahme (AUF) von einer Wandung umgeben ist, welche im wesentlichen prismatische Form hat und an zumindest einer Seitenflächen (SEI) zumindest abschnittsweise offen ist.

3. Montagelement nach Anspruch 1 oder 2, **dadurch gekennzeichnet, dass** die Wandung an einer ihrer geschlossenen Seitenflächen (SEI) in einen zylinderförmigen Abstützsockel (ASS) übergeht, der einen Anschlag (ANS) für den Schaltungsträger (STR) aufweist.

4. Montagelement nach einem der Ansprüche 1 bis 3, **dadurch gekennzeichnet, dass** zumindest ein Schnapphaken (SH1, SH2) an dem Abstützsockel (ASS) angeordnet ist.

5. Montageelement nach Anspruch 1 bis 4, **dadurch gekennzeichnet, dass** es zwei einander gegenüberliegende Schnapphaken (SH1, SH2) mit gegensinnig verlaufenden Einrastrichtungen (EIR) aufweist.

6. Montagelement nach Anspruch 5, **dadurch gekennzeichnet, dass** die beiden Schnapphaken (SH1, SH2) einen konischen Zapfen bilden, der in die Montageöffnung (MOE) des Schaltungsträgers formschlüssig einrastbar ist.

7. Montagelement nach einem der Ansprüche 1 bis 6, **dadurch gekennzeichnet, dass** es auf den Abschnitt (ABS) aufsteckbar ist.

8. Montageelement nach einem der Ansprüche 1 bis 7, **dadurch gekennzeichnet, dass** es aus elektrisch isolierendem Kunststoff hergestellt ist.

9. Montagelement nach einem der Ansprüche 1 bis 7, **dadurch gekennzeichnet, dass** es aus Metall hergestellt ist.

10. Montageelement nach einem der Ansprüche 1 bis 9 zur Verbindung des Bauteiles (BAU) und des Schaltungsträgers (STR) mit einem den Schaltungsträger (STR) und den Bauteil (BAU) fassenden Gehäuse (GEH), **dadurch gekennzeichnet, dass** das Montageelement (MON) zumindest eine von der äußeren Seitenflächen (SEI) der Wandung nach außen abstehende Nase (NAS) aufweist, welche mit einer Öffnung (OEF) einer Seitenwand (SEW) des Gehäuses (GEH) formschlüssig verbindbar ist.

## Claims

1. A mounting element (MON) for connecting a component (BAU) to a circuit board (STR), **characterized in that** said mounting element (MON) has a mounting device (AUF), with which it is positively connectable to a part (ABS) of said component (BAU), and has at least one snap hook (SH1, SH2) which can be locked in place in an assembly opening (MOE) of said circuit board (STR), said mounting device (AUF) having at least one inwardly projecting retaining projection (HF1, HF2) on each of two facing inside surfaces (SE1', SE2'), which retaining projections (HF1, HF2) can be caused to engage complementary recesses (AU1, AU2) of said part (ABS) of said component (BAU).

2. A mounting element as defined in claim 1, **characterized in that** said mounting device (AUF) is surrounded by a wall which is of substantially prismatic shape and which is open on at least one lateral surface (SEI) thereof at at least one section thereof.

3. A mounting element as defined in claim 1 or claim 2, **characterized in that** said wall merges, on one of its closed lateral surfaces (SEI), into a cylindrical supporting pedestal (ASS) having a stop element (ANS) for said circuit board (STR).

4. A mounting element as defined in any one of claims 1 to 3, **characterized in that** at least one snap hook (SH1, SH2) is disposed on said supporting pedestal (ASS).

5. A mounting element as defined in any one of claim 1 to 4, **characterized in that** it has two oppositely disposed snap hooks (SH1, SH2) which latch in contrary directions (EIR).

6. A mounting element as defined in claim 5, **characterized in that** said two snap hooks (SH1, SH2) form a cone-shaped pin which can be positively latched into said assembly opening (MOE) of said circuit board.

7. A mounting element as defined in any one of claims 1 to 6, **characterized in that** it can be plugged onto said part (ABS).

8. A mounting element as defined in any one of claims 1 to 7, **characterized in that** it is made of an electrically insulating plastics material.

9. A mounting element as defined in any one of claims 1 to 7, **characterized in that** it is made of metal.

10. A mounting element as defined in any one of claims 1 to 9 for connecting said component (BAU) and said circuit board (STR) to a housing (GEH) containing said circuit board (STR) and said component (BAU), **characterized in that** said mounting element (MON) has at least one lug (NAS) which projects outwardly from the outer lateral surfaces (SEI) of the wall and which is adapted for positive connection to an opening (OEF) of a side wall (SEW) of said housing (GEH).

## Revendications

1. Elément de montage (MON) pour assembler un composant (BAU) et un support de circuit (STR), **caractérisé en ce que** l'élément de montage (MON) présente un logement (AUF) lui permettant d'être relié par complémentarité de formes à une section (ABS) du composant (BAU), ainsi qu'au moins un crochet à déclic (SH1, SH2) pouvant être encliqueté dans une ouverture de montage (MOE) du support de circuit (STR), le logement (AUF) présentant respectivement au niveau de deux surfaces intérieures en regard l'une de l'autre, au moins un prolongement de maintien (HF1, HF2) saillant vers l'intérieur les prolongements de maintien (HF1, HF2) pouvant être mis en prise avec des évidements (AU1, AU2) complémentaires à ceux-ci prévus dans la section (ABS) du composant (BAU).

2. Elément de montage selon la revendication 1, **caractérisé en ce que** le logement (AUF) est entouré par une paroi d'une forme pour l'essentiel prismatique et étant ouverte, du moins par sections, au niveau d'au moins une surface latérale (SEI).

3. Elément de montage selon la revendication 1 ou 2, **caractérisé en ce que** la paroi, au niveau de l'une de ses surfaces latérales (SEI) fermées, passe dans un socle d'appui (ASS) cylindrique qui présente une butée (ANS) pour le support de circuit (STR).

4. Elément de montage selon l'une quelconque des revendications 1 à 3, **caractérisé en ce qu'**au moins un crochet à déclic (SH1, SH2) est disposé au niveau du socle d'appui (ASS).

5. Elément de montage selon l'une quelconque des revendications 1 à 4, **caractérisé en ce qu'**il présente deux crochets à déclic (SH1, SH2) en regard l'un de l'autre avec des sens d'encliquetage (EIR) s'étendant dans des directions opposées.

6. Elément de montage selon la revendication 5, **caractérisé en ce que** les deux crochets à déclic (SH1, SH2) forment une cheville conique pouvant être encliqueté par complémentarité de formes dans l'ouverture de montage (MOE) du support de circuit.

7. Elément de montage selon l'une quelconque des revendications 1 à 6, **caractérisé en ce qu'**il peut être fixé sur la section (ABS).

8. Elément de montage selon l'une quelconque des revendications 1 à 7, **caractérisé en ce qu'**il est réalisé à partir d'une matière plastique électriquement isolante.

9. Elément de montage selon l'une quelconque des revendications 1 à 7, **caractérisé en ce qu'**il est réalisé à partir d'un métal.

10. Elément de montage selon l'une quelconque des revendications 1 à 9 pour assembler le composant (BAU) et le support de circuit (STR), avec un boîtier (GEH) contenant le support de circuit (STR) et le composant (BAU), **caractérisé en ce que** l'élément de montage (MON) présente au moins un tenon (NAS) saillant des surfaces latérales extérieures (SEI) de la paroi vers l'extérieur et pouvant être relié par complémentarité de formes à l'ouverture (OEF) d'une paroi latérale (SEW) du boîtier (GEH).
